# FASCICULE DE BREVET EUROPEEN

(11) **EP 0 996 766 B1**
(45) Date de publication et mention de la délivrance du brevet: **21.08.2002**
(21) Numéro de dépôt: 98932195.5
(22) Date de dépôt: 12.06.1998
(51) Int. Cl.: C23C 16/40, C23C 16/44, H01J 17/49

(54) **PROCEDE DE REALISATION D'UN DEPOT A BASE DE MAGNESIE**
VERFAHREN ZUM HERSTELLEN EINER MAGNESIUMOXIDHALTIGEN SCHICHT
METHOD FOR PRODUCING A MAGNESIA BASED DEPOSIT

(30) Priorité: 24.06.1997 FR 9707853
(43) Date de publication de la demande: 03.05.2000
(73) Titulaire: THOMSON multimedia S.A., 92648 Boulogne Cedex (FR)
(72) Inventeur: BARET, Guy-Thomson-CSF Propriété Intellectuelle, F-94117 Arcueil Cedex (FR); LABEAU, Michel-Thomson-CSF Propriété Intellectuell, F-94117 Arcueil Cédex (FR); RENAULT, Olivier-Thomson-CSF Propriété Intellectue, F-94117 Arcueil Cédex (FR)
(74) Mandataire: Ruellan-Lemonnier, Brigitte
(86) Numéro de dépôt international: FR9801240
(87) Numéro de publication internationale: WO98059090

(56) Documents cités:
- FR-A- 2 738 392
- STRYCKMANS O ET AL: "FORMATION OF MGO FILMS BY ULTRASONIC SPRAY PYROLYSIS FROM BETA-DIKETONATE" THIN SOLID FILMS, vol. 283, no. 1/02, 1 septembre 1996, pages 17-25, XP000642761
- ANONYMOUS: "Inexpensive Method for the Application of High Secondary Emission Protective Coatings Onto Plasma Display Panels" IBM TECHNICAL DISCLOSURE BULLETIN, vol. 27, no. 7B, décembre 1984, page 4478 XP002058654 NEW YORK, US
- KOIWA I ET AL: "Preparation of MgO protective layer for AC-type plasma display panel by means of screen-printing" JOURNAL OF THE ELECTROCHEMICAL SOCIETY, MAY 1995, USA, vol. 142, no. 5, pages 1396-1401, XP002058655 ISSN 0013-4651

## Description

La présente invention est relative à la fabrication de panneaux de visualisation et en particulier de panneaux à plasma.

Un panneau à plasma comporte deux dalles diélectriques, comportant chacune au moins un réseau d'électrodes conductrices. Ces dalles, formées à partir d'un substrat de verre, sont assemblées l'une à l'autre de manière étanche, les réseaux d'électrodes étant sensiblement orthogonaux. Les deux dalles délimitent un espace rempli de gaz. Chaque intersection d'électrodes définit une cellule où peuvent s'effectuer des décharges dans le gaz.

Dans ce type de panneau de visualisation, les dalles comportent une couche diélectrique typiquement de type émail qui isole les électrodes du gaz. Cette couche diélectrique limite le courant de décharge en stockant les charges créées par l'ionisation et confère au panneau un effet mémoire.

En alimentant les électrodes avec un signal d'entretien alternatif, on peut dissocier les fonctions d'adressage et de génération d'énergie lumineuse ce qui permet de réaliser des panneaux de grandes dimensions. Ce type de panneau de visualisation est d'une grande simplicité technologique et particulièrement robuste.

La couche diélectrique est généralement réalisée par un émail à base d'oxyde de plomb, de silice et d'oxyde de bore (PbO, SiO₂, B₂O₃). La couche diélectrique placée sur la dalle avant du panneau, c'est-à-dire la face vue par un observateur, est généralement transparente, tandis que celle placée sur la dalle arrière est généralement blanche pour renvoyer un maximum de lumière vers l'avant.

Il est classique de recouvrir la surface diélectrique des dalles d'un dépôt à base de magnésie (oxyde de magnésium MgO) pour la protéger du bombardement par les ions du gaz, pour diminuer la tension nécessaire pour que se produise une décharge et pour garantir la stabilité dans le temps de la tension nécessaire pour la décharge.

Dans les panneaux à plasma en couleurs, le gaz est généralement un mélange de néon, de xénon et d'hélium. L'ionisation du gaz provoque une émission d'ultraviolets qui excite une mosaïque de luminophores déposée sur la couche à base de magnésie de l'une des deux dalles entre deux électrodes d'un réseau.

Le dépôt à base de magnésie doit avoir un coefficient d'émission secondaire élevé et être parfaitement isolant électriquement. Sa réalisation. ne doit pas altérer la dalle diélectrique. Le dépôt à base de magnésie doit supporter sans se dissocier les traitements ultérieurs que doit subir la dalle tout en continuant à jouer son rôle de protection de la couche diélectrique. Les traitements ultérieurs auxquels est soumise une dalle sont : le dépôt des luminophores qui intègre des traitements en phase aqueuse, et l'opération de scellement qui se fait à des températures d'environ 400°C.

Actuellement le dépôt à base de magnésie est réalisé par évaporation sous vide. Cette opération nécessite une chambre à vide secondaire fonctionnant avec une pression inférieure ou égale à 10⁻⁵ hectopascals. Un canon à électrons est placé dans la chambre à vide, il chauffe de la magnésie en la bombardant, ce qui provoque son évaporation et son dépôt sur la dalle diélectrique Le dépôt se fait aux alentours de 100°C. L'installation permettant ce dépôt est coûteuse. La durée du dépôt est relativement longue car des épaisseurs comprises entre environ 300 et 500 nanomètres sont requises et les cadences de production ne peuvent être élevées.

Cette opération de dépôt déjà coûteuse pour des dalles de taille moyenne (49 centimètres de diagonale) le devient encore beaucoup plus pour des dalles plus grandes alors qu'un des points prometteurs des panneaux de visualisation à plasma est d'être tout à fait adaptés aux grands formats (150 centimètres de diagonale voire plus).

Un autre inconvénient important de ce procédé de dépôt par évaporation sous vide est relatif à la qualité du dépôt. Les inventeurs se sont aperçus que les dépôts obtenus n'étaient pas suffisamment stables mécaniquement et chimiquement, qu'ils se dégradaient sous l'effet du bombardement ionique, en particulier sous l'effet du bombardement des ions xénon et qu'ils ne jouaient pas correctement leur rôle de protection lors de la réalisation du dépôt des luminophores. En effet, il s'avère que le dépôt par évaporation sous vide conduit à une couche à base de magnésie peu dense, avec des espaces intergranulaires relativement importants ce qui la rend perméable à l'eau. C'est ce qui explique d'une part sa sensibilité au bombardement ionique et d'autre part son inefficacité à protéger correctement la couche diélectrique lors du traitement en phase aqueuse. L'eau en s'infiltrant dans les pores ainsi formés arrive à atteindre la couche diélectrique et la détériore. Des mesures ont montré des porosités d'environ 30 à 40%.

L'attaque ionique et la détérioration de la couche diélectrique entraînent une pollution de la magnésie, la contamination de l'intérieur de l'espace gazeux et une durée de vie insuffisante des panneaux ainsi réalisés.

La présente invention à pour objet de proposer un procédé de réalisation d'un dépôt à base de magnésie à la surface diélectrique d'une dalle en verre de panneau de visualisation qui conduit à une couche imperméable à l'eau de manière à ce qu'elle soit pratiquement insensible à l'attaque ionique et qu'elle n'entraîne pas de détérioration de la dalle lors du dépôt ou lors des traitements ultérieurs que celle-ci sera amenée à subir. Il faut notamment avoir à l'esprit que la surface diélectrique de la dalle ne peut être chauffée de manière intensive, au delà d'environ 430°C, sous peine de voir apparaître des déformations ce qui n'est pas acceptable.

Pour y parvenir le procédé selon l'invention comporte au moins les étapes suivantes:
- création d'un brouillard à partir d'un composé organométallique du magnésium dissout dans un solvant,
- acheminement du brouillard vers la surface diélectrique de la dalle,
- évaporation du solvant à l'approche de la surface diélectrique de la dalle qui est portée à une température comprise entre environ 380°C et 430°C,
- pyrolyse du composé organométallique conduisant au dépôt à base de magnésie à la surface de la dalle et à l'évaporation du radical organique du composé, ce dépôt étant pratiquement imperméable à l'eau.

Comme composé organométallique de l'acétate de magnésium ou de l'acétyl acétonate de magnésium peut être utilisé.

Un solvant organique tel que le butanol ou le méthanol par exemple, peut être choisi.

Le brouillard est obtenu, de préférence à l'aide d'un générateur à ultrasons plongé dans la solution, on obtient alors une nébulisation particulièrement homogène.

Le brouillard est transporté vers la surface diélectrique de la dalle. à l'aide d'un gaz vecteur tel que de l'air, de l'oxygène pur ou un mélange d'azote et d'oxygène, ce gaz contribuant à la transformation par oxydation du magnésium en magnésie.

Il est préférable que le brouillard soit préchauffé pendant son acheminement, ce préchauffage ayant lieu de préférence dans un conduit dans lequel passe le brouillard. Dans une installation de dépôt en continu, il est intéressant que la dalle soit apte à se déplacer par rapport à une buse par laquelle se termine le conduit.

Il est envisageable que le dépôt à base de magnésie contienne un dopant améliorant ses propriétés électriques, tel que par exemple l'oxyde de calcium, l'oxyde d'yttrium, l'oxyde de barium.

Dans cette variante, la solution contiendra un composé organométallique dont le radical métallique correspond au dopant.

La présente invention sera mieux comprise à la lecture de la description qui suit de modes de mise en oeuvre donnés à titre d'exemples non limitatifs. Cette description se réfère aux figures jointes qui représentent:
- la figure 1 un schéma d'une installation pour la mise en oeuvre du procédé selon l'invention ;
- les figures 2a, 2b des représentations de l'état de surface de dépôts de magnésie obtenus respectivement par évaporation sous vide et par le procédé selon l'invention.

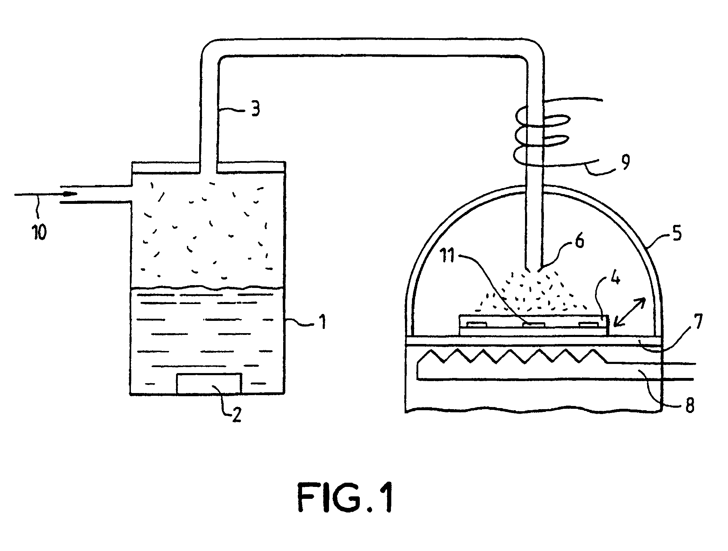

Selon l'invention le procédé de réalisation d'un dépôt à base de magnésie à la surface diélectrique d'une dalle d'un panneau de visualisation comporte une étape qui consiste à créer un brouillard à partir d'une solution contenant un composé organométallique du magnésium dissout dans un solvant. On se réfère à la figure 1.

La solution est contenue dans un récipient 1 équipé d'un générateur 2 de gouttelettes pour nébuliser la solution. Ce générateur est de préférence un générateur d'ultrasons qui plonge dans la solution dans la partie basse du récipient 1. Il est préférable que la solution soit à température sensiblement constante et que le récipient 1 soit thermostaté. Une nébulisation par ultrasons donne une bonne homogénéité du brouillard avec des gouttelettes sensiblement de la même taille, ce qui conduit à un dépôt dont l'épaisseur est sensiblement uniforme. D'autres techniques de nébulisation pourraient toutefois être envisagées par exemple mécanique.

Un gaz vecteur 10 est introduit dans la partie haute du récipient 1 de manière à assurer le transport du brouillard vers la surface diélectrique de la dalle 4. La dalle 4 représentée, que l'on suppose être celle d'un panneau de visualisation à plasma, est formée d'un substrat de verre dont la surface est émaillée et qui comporte des électrodes 11 sous l'émail.

Le récipient 1 est fermé et se termine dans sa partie haute par un conduit 3 destiné à être parcouru par le brouillard. Ce conduit 3 débouche dans une enceinte 5 à proximité de la surface de la dalle 4 et se termine par une buse 6.

Le composé organométallique peut être par exemple de l'acétate de magnésium ou de l'acétyl acétonate de magnésium. Le solvant peut être organique et choisi parmi le butanol, le méthanol par exemple.

Comme concentration de la solution la limite de solubilité donne des résultats satisfaisants.

Le gaz vecteur 10 sera de préférence de l'air ce qui simplifie la réalisation de l'installation et contribue à l'oxydation du magnésium en magnésie. Toutefois on pourrait aussi utiliser comme gaz vecteur de l'oxygène pur ou tout mélange d'azote et d'oxygène. Un débit de 2 litres par minute est suffisant pour transporter le brouillard si la section du conduit est de quelques centimètres carrés.

Dans de telles conditions, la création du brouillard et son acheminement peuvent se faire à température ambiante et pression atmosphérique ce qui est particulièrement simple à réaliser et beaucoup moins onéreux qu'une installation sous vide. Toutefois il est préférable de préchauffer le brouillard avant qu'il n'atteigne la buse, en le portant à une température comprise entre environ 200° C et 300° C. Ce chauffage peut se faire en chauffant le conduit 3. Un dispositif de chauffage est représenté sur la figure 1 avec la référence 9.

Dans l'enceinte 5, la surface diélectrique de la dalle 4 est portée à une température comprise entre environ 380°C et 430°C, ce qui permet une évaporation du solvant à son approche et une dissociation par pyrolyse du composé organométallique, conduisant à un dépôt de magnésie sur la surface diélectrique et une évaporation du radical organique du composé. Dans l'enceinte 5 on conservera aussi de préférence la pression atmosphérique.

De telles conditions conduisent à un dépôt de magnésie polycristallisé, pratiquement sans zone amorphe et suffisamment dense pour être pratiquement imperméable à l'eau. Un tel dépôt, beaucoup plus stable mécaniquement et chimiquement, résiste au bombardement ionique. En limitant la température superficielle de la dalle à environ 430°C, on ne risque pas de détériorer sa couche émaillée.

Le chauffage de la surface de la dalle 4 peut être réalisé à l'aide d'une plaque 7 chauffée par résistance électrique 8 sur laquelle est disposée la dalle. Mais d'autres dispositifs de chauffage sont envisageables par exemple utilisation d'un chauffage à infrarouge.

Dans une installation industrielle de dépôt en continu, il est préférable de déplacer les dalles 4 et de garder fixe la buse 6.

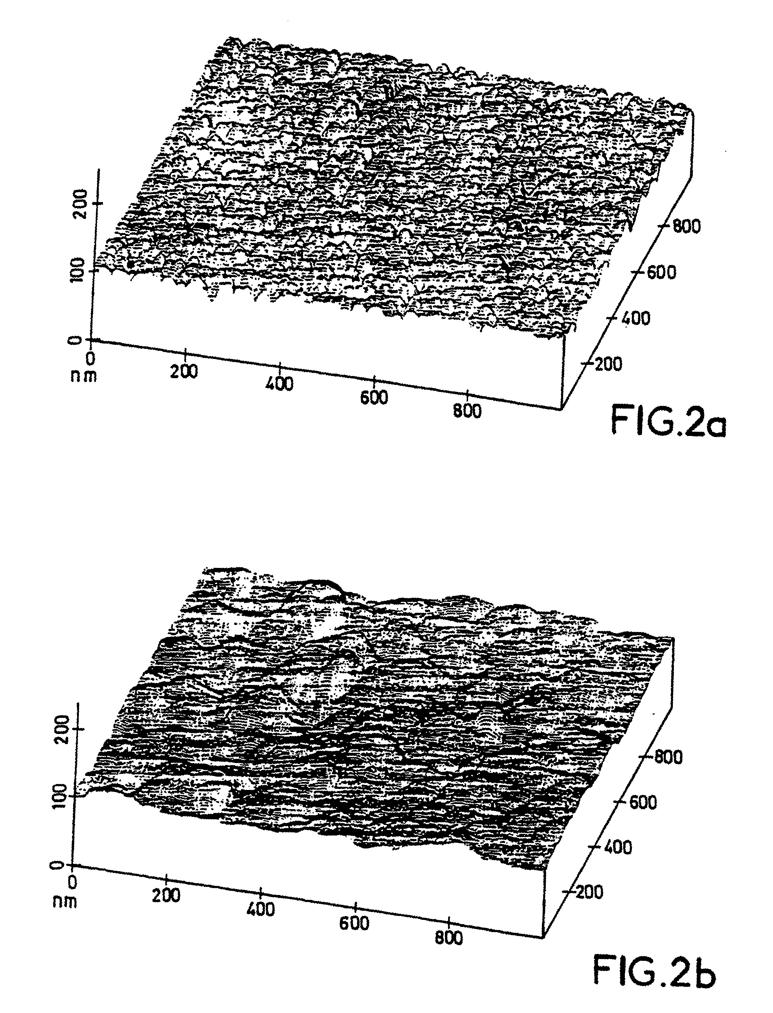

Les figures 2a, 2b sont des représentations de l'état de surface de dépôts de magnésie obtenus respectivement par évaporation sous vide et par le procédé selon l'invention. Ces représentations sont obtenues par examen au microscope à force atomique (AFM).

La figure 2b présente un état de surface beaucoup plus lisse que celui de la figure 2a avec des grains trois à quatre fois plus gros. L'espace intergranulaire semble quasi nul sur la figure 2b alors que sur la figure 2a des grains non jointifs sont parfaitement visibles.

L'examen par diffraction de rayons X montre des orientations cristallines <111> et/ou <200> très marquées et ne permet pas de détecter de phase amorphe.

Une pluralité d'essais de dépôts de magnésie, par le procédé qui vient d'être décrit ont été réalisés, ils mettent en évidence que la qualité cristalline et la pureté du dépôt sont parfaitement reproductibles d'un essai à un autre dans les mêmes conditions. Les dalles recouvertes de magnésie sont tout à fait compatibles avec les caractéristiques électriques de fonctionnement d'un panneau à plasma et leur durée de vie à été augmentée.

Au lieu de déposer de la magnésie pure sur la dalle, on peut être amené à lui adjoindre un dopant ce qui permet d'améliorer ses propriétés électriques et notamment de diminuer la tension nécessaire pour obtenir une décharge. Le dopant peut être de l'oxyde de calcium (CaO), de l'oxyde d'yttrium (Y₂O₃) ou de l'oxyde de barium (BaO) par exemple. Dans ce cas, la solution contiendra un composé organométallique dissout dans le solvant dont le radical métallique correspond au dopant. Dans l'exemple de l'oxyde de calcium le composé organométallique pourra être de l'acétate de calcium par exemple. Dans le dépôt réalisé la magnésie reste prépondérante car l'oxyde de calcium n'a un rôle que de dopant. Au niveau de la surface diélectrique chauffée l'acétate de calcium va aussi se dissocier par pyrolyse et de l'oxyde de calcium va se déposer en mélange avec la magnésie.

## Revendications

1. Procédé de réalisation d'un dépôt à base de magnésie, à la surface diélectrique d'une dalle (4) en verre d'un panneau de visualisation, **caractérisé en ce qu'**il comporte au moins les étapes suivantes :
- création d'un brouillard à partir d'acétate de magnésium dissout dans un solvant,
- acheminement du brouillard, à l'aide d'un gaz vecteur contribuant à la transformation par oxydation du magnésium en magnésie, vers la surface diélectrique de la dalle (4), portée à une température comprise entre environ 380°C et 430°C, ce qui conduit à l'évaporation du solvant à son approche de la surface diélectrique de la dalle (4), à une dissociation par pyrolyse de l'acétate de magnésium, à une évaporation du radical organique de l'acétate de magnésium, au dépôt à base de magnésie à la surface de la dalle sans qu'elle ne soit déformée, ce dépôt étant pratiquement imperméable à l'eau .

2. Procédé de réalisation d'un dépôt à base de magnésie selon la revendication 1, **caractérisé en ce que** la concentration de l'acétate de magnésium dans le solvant est la limite de solubilité.

3. Procédé de réalisation d'un dépôt à base de magnésie selon l'une des revendications 1 ou 2, **caractérisé en ce que** le solvant est un solvant organique.

4. Procédé de réalisation d'un dépôt à base de magnésie selon la revendication 3, **caractérisé en ce que** le solvant est du butanol ou du méthanol.

5. Procédé de réalisation d'un dépôt à base de magnésie selon l'une des revendications 1 à 4, **caractérisé en ce que** la surface diélectrique de la dalle (4) est émaillée.

6. Procédé de réalisation d'un dépôt à base de magnésie selon l'une des revendications 1 à 5, **caractérisé en ce que** le brouillard est obtenu à l'aide d'un générateur à ultrasons (2) plongé dans la solution.

7. Procédé de réalisation d'un dépôt à base de magnésie selon l'une des revendications 1 à 6, **caractérisé en ce que** la solution est maintenue à température sensiblement constante.

8. Procédé de réalisation d'un dépôt à base dé magnésie selon l'une des revendications 1 à 7, **caractérisé en ce que** le gaz vecteur est de l'air, de l'oxygène pur ou un mélange d'air et d'azote.

9. Procédé de réalisation d'un dépôt à base de magnésie selon l'une des revendications 1 à 8, **caractérisé en ce que** brouillard est transporté vers la surface diélectrique de la dalle (4) dans un conduit (3) se terminant par une buse (6), et est préchauffé dans le conduit.

10. Procédé de réalisation d'un dépôt à base de magnésie selon la revendication 9, **caractérisé en ce que** la dalle (4) est apte à se déplacer par rapport à une buse (6) par laquelle se termine le conduit.

11. Procédé de réalisation d'un dépôt à base de magnésie selon l'une des revendications 1 à 10, **caractérisé en ce que** le dépôt à base de magnésie contient un dopant améliorant ses propriétés électriques.

12. Procédé de réalisation d'un dépôt à base de magnésie selon la revendication 11, **caractérisé en ce que** le dopant est choisi parmi l'oxyde de calcium, l'oxyde d'yttrium, l'oxyde de barium.

13. Procédé de réalisation d'un dépôt à base de magnésie selon l'une des revendications 11 ou 12, **caractérisé en ce que** la solution contient également un composé organométallique dont le radical métallique correspond au dopant.

14. Procédé de réalisation d'un dépôt à base de magnésie selon l'une des revendications 1 à 13, **caractérisé en ce que** le panneau de visualisation est un panneau à plasma.

## Patentansprüche

1. Verfahren zur Herstellung einer Schicht auf der Basis von Magnesiumoxid auf der dielektrischen Oberfläche einer Glasplatte (4) eines Wiedergabeschirms, **gekennzeichnet durch** wenigstens folgende Schritte:
- Bildung eines Nebels aus einem in einem Lösungsmittel gelösten Magnesiumacetats,
- Beförderung des Nebels mittels eines Traggases, das zu der Umsetzung des Magnesiums in Magnesiumoxyd **durch** Oxidation beiträgt, zu der dielektrischen Oberfläche der Platte (4), die bei einer Temperatur zwischen ungefähr 380 °C und 430 °C gehalten wird, was zu einer Verdampfung des Lösungsmittels bei seiner Annäherung an die dielektrische Oberfläche der Platte (4) führt, bei einer Dissoziation **durch** Pyrolyse des Magnesiumacetats bei einer Verdampfung des organischen Radikal des Magnesiumacetats an der Schicht auf der Basis von Magnesiumoxid an der Oberfläche der Platte, ohne daß diese deformiert wird, wobei die Schicht praktisch wasserundurchlässig ist.

2. Verfahren zur Herstellung einer Schicht auf der Basis von Magnesiumoxid nach Anspruch 1, **dadurch gekennzeichnet, daß** die Konzentration des Magnesiumacetats in dem Lösungsmittel die Grenze der Löslichkeit ist.

3. Verfahren zur Herstellung einer Schicht auf der Basis von Magnesiumoxid nach einem der Ansprüche 1 oder 2, **dadurch gekennzeichnet, daß** das Lösungsmittel ein organisches Solvant ist.

4. Verfahren zur Herstellung einer Schicht auf der Basis von Magnesiumoxid nach Anspruch 3, **dadurch gekennzeichnet, daß** das Lösungsmittel Butanol oder Methanol ist.

5. Verfahren zur Herstellung einer Schicht auf der Basis von Magnesiumoxid nach einem der Ansprüche 1 bis 4, **dadurch gekennzeichnet, daß** die dielektrische Oberfläche der Platte (4) emailliert ist

6. Verfahren zur Herstellung einer Schicht auf der Basis von Magnesiumoxid nach einem der Ansprüche 1 bis 5, **dadurch gekennzeichnet, daß** der Nebel mittels eines in die Lösung eintauchenden Ultraschallgenerators (2) gewonnen wird.

7. Verfahren zur Herstellung einer Schicht auf der Basis von Magnesiumoxid nach einem der Ansprüche 1 bis 6, **dadurch gekennzeichnet, daß** die Lösung bei einer im wesentlichen konstanten Temperatur gehalten wird.

8. Verfahren zur Herstellung einer Schicht auf der Basis von Magnesiumoxid nach einem der Ansprüche 1 bis 7, **dadurch gekennzeichnet, daß** das Traggas Luft, reiner Sauerstoff oder eine Mischung von Luft und Stickstoff ist.

9. Verfahren zur Herstellung einer Schicht auf der Basis von Magnesiumoxid nach einem der Ansprüche 1 bis 8, **dadurch gekennzeichnet, daß** der Nebel zu der dielektrischen Oberfläche der Platte (4) in einem Rohr geführt wird, das in einer Düse (6) endet, und in dem Rohr vorgewärmt wird.

10. Verfahren zur Herstellung einer Schicht auf der Basis von Magnesiumoxid nach Anspruch 9, **dadurch gekennzeichnet, daß** die Platte (4) in der Lage ist, gegenüber einer Düse (6), mit der das Rohr endet, verschoben zu werden.

11. Verfahren zur Herstellung einer Schicht auf der Basis von Magnesiumoxid nach einem der Ansprüche 1 bis 10, **dadurch gekennzeichnet, daß** die Schicht auf der Basis von Magnesiumoxid ein Dopant enthält, das ihre elektrischen Eigenschaften verbessert.

12. Verfahren zur Herstellung einer Schicht auf der Basis von Magnesiumoxid nach Anspruch 11, **dadurch gekennzeichnet, daß** das Dopant unter Calciumoxid, Yttriumoxid und Bariumoxid ausgewählt ist.

13. Verfahren zur Herstellung einer Schicht auf der Basis von Magnesiumoxid nach einem der Ansprüche 11 oder 12, **dadurch gekennzeichnet, daß** die Lösung außerdem eine metallorganische Zusammensetzung enthält, deren metallisches Radikal dem Dopant entspricht.

14. Verfahren zur Herstellung einer Schicht auf der Basis von Magnesiumoxid nach einem der Ansprüche 1 bis 13, **dadurch gekennzeichnet, daß** der Wiedergabeschirm ein Plasmaschirm ist.

## Claims

1. Process for producing a magnesia-based coating on the dielectric surface of a glass tile (4) of a display panel, **characterized in that** it comprises at least the following steps:
- creation of a mist from magnesium acetate dissolved in a solvent;
- transfer of the mist, by means of a carrier gas contributing to the conversion of the magnesium into magnesia by oxidation, to the dielectric surface of the tile (4), the latter being raised to a temperature of between about 380°C and 430°C, thereby resulting in the evaporation of this solvent as it approaches the dielectric surface of the tile (4), in dissociation of the magnesium acetate by pyrolysis, in evaporation of the organic radical of the magnesium acetate and in the magnesia-based coating on the surface of the tile without the latter being deformed, this coating being virtually impermeable to water.

2. Process for producing a magnesia-based coating according to Claim 1, **characterized in that** the concentration of magnesium acetate in the solvent is the solubility limit.

3. Process for producing a magnesia-based coating according to either of Claims 1 and 2, **characterized in that** the solvent is an organic solvent.

4. Process for producing a magnesia-based coating according to Claim 3, **characterized in that** the solvent is butanol or methanol.

5. Process for producing a magnesia-based coating according to one of Claims 1 to 4, **characterized in that** the dielectric surface of the tile (4) is enamelled.

6. Process for producing a magnesia-based coating according to one of Claims 1 to 5, **characterized in that** the mist is obtained by means of an ultrasound generator (2) immersed in the solution.

7. Process for producing a magnesia-based coating according to one of Claims 1 to 6, **characterized in that** the solution is maintained at an approximately constant temperature.

8. Process for producing a magnesia-based coating according to one of Claims 1 to 7, **characterized in that** a carrier gas is air, pure oxygen or an air/nitrogen mixture.

9. Process for producing a magnesia-based coating according to one of Claims 1 to 8, **characterized in that** mist is transported to the dielectric surface of the tile (4) in a pipe (3) terminating in a nozzle (6) and is preheated in the pipe.

10. Process for producing a magnesia-based coating according to Claim 9, **characterized in that** the tile (4) is capable of being moved with respect to a nozzle (6) in which the pipe terminates.

11. Process for producing a magnesia-based coating according to one of Claims 1 to 10, **characterized in that** the magnesia-based coating contains a dopant for improving its electrical properties.

12. Process for producing a magnesia-based coating according to Claim 11, **characterized in that** the dopant is chosen from calcium oxide, yttrium oxide and barium oxide.

13. Process for producing a magnesia-based coating according to either of Claims 11 and 12, **characterized in that** the solution also contains an organometallic compound, the metal radical of which corresponds to the dopant.

14. Process for producing a magnesia-based coating according to one of Claims 1 to 13, **characterized in that** the display panel is a plasma panel.
